# EUROPEAN PATENT APPLICATION

(11) **EP 4 693 350 A1**
(43) Date of publication of application: **11.02.2026**
(21) Application number: 24193806.7
(22) Date of filing: 09.08.2024
(51) Int. Cl.: H01F 7/20, G01R 33/385

(54) **METHOD FOR GENERATING A MAGNETIC FIELD PATTERN**

(71) Applicant: NATIONAL CENTER FOR SCIENTIFIC RESEARCH "DEMOKRITOS" (NCSRD), 15341 Agia Paraskevi Attikis (GR); Laboratorio Iberico Internacional de Nanotecnologia LIN (INL), 4715-330 Braga (PT); Universita degli Studi di Genova (UniGe), 16126 Genova (IT)
(72) Inventor: Ntallis, Nikolaos, Agia Paraskevi (GR); Trohidou, Kalliopi, Agia Paraskevi (GR); Sadewasser, Sascha, Braga (PT); Boehnert, Tim, Braga (PT); Anacleto, Pedro Alexandre Marques, Braga (PT); Colombara, Diego, Genova (IT)
(74) Representative: Kouzelis, Dimitrios

(57) **Abstract**

The present invention refers to a method for generating magnetic field patterns aimed in particular at analyzing specimens via nuclear magnetic resonance imaging (MRI), or magnetic induction imaging at the microscale, or inducing masking of a substrate via magnetic, magnetorheological, or ferrofluid lithohraphy (101). The method comprises the step of generating a magnetic field pattern by using an array (103) with a plurality of current lines (1, 2; 1) that each are in the form of a meander. The invention further refers to a device comrpising an array (103) with a plurality of current lines (1, 2; 1) that each are in the form of a meander.

## Description

The present invention refers to a device and method for generating a magnetic field pattern, in particular to (but not limited to) enable the preferential spin orientation of atomic nuclei of specimens intended for nuclear magnetic resonance imaging (MRI), Magnetic Induction Imaging (Mil), or Magnetic Resonance Microscopy (MRM) at the microscale or to remotely induce the masking of a substrate for nanofabricating functional devices such as photovoltaic solar panels of desired geometry.

With regard to the latter application, nanofabrication represents the most important basis for the evolution of electronics, optoelectronics, photonics, and information technologies. One of the key processes in the fabrication of functional devices for those technological fields is patterning. Patterning is commonly referred to as lithography and it has been accomplished almost entirely by photolithography by a pre-designed set of patterns in the form of masks. The latter is the engine that has powered the semiconductor revolution from the outset, having met the industry's ever tightening requirements, down to outstanding patterning resolutions. Photolithography is the most common technique used to produce heterogeneous substrates when the critical length scales, and thus masking ability, needed to be traced are below a few micrometers. Such substrates are used in information and communication technologies, biomedicine and energy applications.

A patterning method by remotely controlled masks was first introduced in the United States, combining structured magnetic fields with conventional ferrofluids to fabricate features with micron-scale resolution. The technique was named ferrofluid lithography and later evolved through field-induced self-assembly, leading to remarkable resolutions down to 250 nm.

It is an object of the present invention to provide an efficient, reusable, and tuneable method for generating a magnetic field, in particular a magnetic field pattern, as well as a device for generating a magnetic field pattern, in particular a magnetic field gradient pattern.

The proposed method for generating a magnetic field pattern, in particular a magnetic field gradient pattern, comprises the step of generating the magnetic field pattern, in particular the magnetic field gradient pattern, by using an array with a plurality of current lines that each are in the form of a meander. The current lines are in particular segments composed of material capable of conducting electrical currents. The proposed method has the advantage that a magnetic field distribution with almost homogenous field regions (spots) can be produced to provide high contrast and a sufficient gradient between them. It has in particular been demonstrated that a meander pattern array can produce a very well-defined spot pattern. Moreover, very high gradients can be achieved due to the presence of sharp edges due to the meander shape. The advantage of such a structure is that it enables to generate useful patterns by means of a single layer of current lines, in other words current lines on the same plane. Depending on the magnitude and direction of the applied field, two-dimensional (2D) closed-packed dot arrays and one-dimensional grating structures can be assembled with the present method. The usage of current lines allows to construct arbitrary 2D structures by varying the current direction. Moreover, the strength of the fields can be tuned by tuning the intensity of the currents.

Within the context of the present invention, a meander is in particular a shape that has a number/plurality of consecutive open orthogonal loops on the same plane pointing in opposite transverse directions. In other words, a meander is in particular an arrangement of open orthogonal loops pointing in opposite transverse directions.

The expression "plurality of current lines" means that the array has at least two current lines or in other words two or more current lines that are in the form of a meander. In other words, the proposed method for generating a magnetic field pattern can be described as comprising the step of generating a magnetic field pattern by using at least two, i.e. two or more, current lines that each are in the form of a meander. The current lines are in particular segments composed of material capable of conducting electrical currents.

It is further understood that the expression "each are in the form of a meander" refers to the plurality of current lines of the array and not to all current lines that may be used for generating the magnetic field pattern. In other words, for generating the magnetic field pattern, a combination of the array with the plurality of current lines that are in the form of a meander and at least one more current line that is not in the form of a meander can be used.

In an advantageous embodiment, all the current lines that are used for generating the magnetic field pattern may have the form of a meander.

Advantageously, an apparent length of at least one of the plurality of current lines of the array may be between 0.5mm and 5m. Advantageously, an apparent length of each current line of the plurality of current lines of the array may be between 0.5mm and 5m. According to an embodiment, the apparent length of at least one, in particular each current line, of the plurality of current lines of the array may be between 0.9mm and 1.1mm, in particular equal to 1mm. According to an embodiment, all current lines of the array may have the same apparent length. The term "apparent length" of a respective current line means in particular the dimension parallel to a longitudinal axis of the meander of the respective current line, i.e. does not correspond to the actual length of the current line if the current line was straight and not in the form of a meander. In other words, the apparent length is smaller than the actual length of the current line measured along the meander. By choosing said apparent length, the fabrication of the respective current line can be simplified.

Advantageously, a width of at least one, in particular each current line, of the plurality of current lines of the array may be between 10nm and 2cm. According to an embodiment, a width of at least one, in particular each current line, of the plurality of current lines of the array, may be between 40µm and 60µm, in particular equal to 50µm. This embodiment may refer to a method for remotely inducing the masking of a substrate.

Within the context of the present invention, the width of a respective current line is understood as the actual width of the current line. The advantage of a respective current line having said width is that large currents (e.g. up to 1A) can pass through the current line without compromising operational conditions. The width of at least two current lines of the plurality of current lines of the array may be the same or different from each other. Advantageously, the width of all current lines of the array may be the same.

Advantageously, a thickness of at least one, in particular each current line, of the plurality of current lines of the array may be between 0.4µm and 2cm. According to an embodiment, a thickness of at least one, in particular each current line, of the plurality of current lines may be between 0.4µm and 0.6µm, in particular equal to 0.5µm. This embodiment may refer to a method for remotely inducing the masking of a substrate. Advantageously, all current lines of the plurality of the current lines of the array may have the same thickness. The advantage of a respective current line having said thickness is that such a line can be easily fabricated with small structural distortions, in particular for both Cu and AlSiCu, which are the most common materials used for the current lines, albeit it is understood that such dimensions can vary depending on the material employed to fabricate the current lines.

Advantageously, at least two of the plurality of current lines of the array are shaped identically, i.e., with the same dimensions. Advantageously, all current lines of the plurality of current lines of the array are shaped identically.

Advantageously, at least two current lines of the plurality of current lines of the array may be arranged on the same plane. An in-plane separation of said at least two current lines may advantageously be between 20nm and 1m. According to an embodiment, all current lines of the plurality of current lines of the array may be arranged on the same plane, wherein an in-plane separation of said at least two current lines may advantageously be between 20nm and 1m. According to an embodiment, at least two current lines of the plurality of current lines of the array may be arranged on the same plane, wherein an in-plane separation of said at least two current lines may advantageously be between 100µm and 250µm. This embodiment may refer to a method for remotely inducing the masking of a substrate. In particular, all current lines of the plurality of current lines of the array may be arranged on the same plane, wherein an in-plane separation of said at least two current lines may advantageously be between 100µm and 250µm.

These values for the separation influence the spatial resolution of the magnetic pattern. Thus, by choosing the in-plane separation, on demand tuning of the spatial resolution can be achieved according to the respective application for which the proposed method is used.

The in-plane separation can in particular be understood as the-center-to-center distance between two open consecutive orthogonal loops of the respective meander.

Advantageously, at least two current lines of the plurality of the current lines of the array may be arranged parallel to each other, i.e. at different heights/on different planes, and in particular at a height separation between 0.5µm and 5cm. In other words, at least two current lines of the plurality of the current lines of the array may advantageously be placed at a distance in a direction normal to the planes of the current lines. Here, the distance corresponds to the aforementioned height separation. According to an embodiment, all current lines of the plurality of the current lines of the array may be arranged parallel to each other and in particular at a height separation between 0.5µm and 5cm. According to an embodiment, at least two current lines, in particular all current lines, of the plurality of the current lines of the array may be arranged parallel to each other, and in particular at a height separation between 0.5µm and 5µm. This embodiment may refer to a method for remotely inducing the masking of a substrate.

The height separation is in particular the minimum distance between the current lines, i.e. the minimum distance between the bottom of the one current line (upper current line) and the top of the other current line (bottom current line).

It is noted that a height separation equal to zero means that the corresponding current lines are on the same plane.

Advantageously, at least two current lines of the plurality of current lines of the array may be arranged such that they are rotated to each other by an angle between 0 and 180 degrees, preferably by 180 degrees, around an axis perpendicular to the planes of the at least two current lines. The angle is measured between corresponding parts of the current lines, i.e. the meanders of the current lines. In the configuration of a rotation of 180 degrees, the current lines are mirrored to each other.

Advantageously, a value of a current that flows through at least one of the plurality of current lines of the array may be adjustable. In particular, the value may be adjustable between 0.1A and 5A. Furthermore, a direction of a current that flows through at least one of the plurality of current lines of the array may be adjustable. These features may also apply separately or in combination with each other to all current lines of the array. The currents that flow through the plurality of the current lines may be the same or different from each other. According to an embodiment, a value of a current that flows through at least one, in particular all current lines, of the plurality of current lines of the array may be adjustable between 0.1A and 1 A. This embodiment may refer to a method for remotely inducing the masking of a substrate. Reaching values up to 5A or 1A, high values of magnetic fields can be reached. The adjustability of the current that flows through the at least one current line in particular means that there is a control means for adjusting the value of said current.

A current that flows through at least one, in particular all current lines, of the plurality of current lines, may advantageously have a predetermined shape variation. The current can in other words be subject to temporal variations. The predetermined shape variation may for example be a pulse.

At least one of the plurality of current lines of the array may be made of a material that comprises a metal, e.g. gold, silver etc., and/or an intermetallic compound and/or a metallic alloy and/or graphene and/or a superconducting material and/or a semiconductor and/or a topological insulator. In particular, all the current lines of the array may be made of such a material. According to an embodiment, all current lines of the array can be made from the same material.

According to an embodiment, the step of generating a magnetic field pattern by using an array with a plurality of current lines that each are in the form of a meander may advantageously be executed for remotely inducing masking of a substrate, wherein the current lines of the array are parallel to a substrate surface to be masked. The expression that the current lines, i.e. the meanders of the current lines, are parallel to a substrate surface to be masked means in particular that the meander defines a plane that is parallel to said substrate surface. In particular, the substrate surface is parallel to a plane defined by a first axis and a second axis (x-axis and y-axis) of an orthogonal coordinate system. A third axis of the orthogonal coordinate system is perpendicular to the plane defined by the first axis and the second axis and parallel to a normal of said substrate surface. The third axis of the orthogonal coordinate system defines a height direction of the substrate and a thickness direction of a respective current line. Within the context of the present invention, the term "masking" means in particular the construction of a predefined spatial arrangement of magnetic nanoparticles in order to have regions of the substrate covered by nanoparticles and regions of the substrate that are free from nanoparticles, i.e. that are not covered by nanoparticles. Different spatial arrangements can advantageously be achieved via spatially varying magnetic fields produced by the array of current lines. "Masking" can in particular be understood as part of ferrofluid lithography. Thus, in this embodiment, the proposed method for generating a magnetic field pattern can be part of a magnetic lithography method.

Generating the magnetic field pattern with the proposed method for remotely inducing masking of a substrate has the advantage of producing a magnetic field distribution with almost homogenous field regions (spots) to provide high contrast and a sufficient gradient between them in order to drive the magnetic particles. The resolution of the mask can also be tuned by varying the geometric characteristics of the current lines. As the mask is constructed by only setting up currents, it can be reusable. Moreover, the mask can be tuned by changing the intensity and orientation of the currents, including as a function of time. In particular, when the current that flows through at least one of the current lines of the array reaches values up to 1A, high values of magnetic fields can be reached and thus a large variety of nanoparticles can be used in the masking process.

According to another embodiment, the step of generating a magnetic field pattern by using an array with a plurality of current lines that each are in the form of a meander may advantageously be executed for setting a spin orientation of atomic nuclei of a specimen intended for nuclear magnetic resonance imaging (MRI) at the microscale. As the proposed structure of the array can create on demand gradients of the magnetic field by parameterization of the structure, it can in particular be used for optimizing MRI operations for analytical and biomedical applications.

According to another embodiment, the step of generating a magnetic field pattern by using an array with a plurality of current lines that each are in the form of a meander may advantageously be executed for generating a magnetic field pattern on a sample, subjected to magnetic induction imaging (MII) at the microscale.

Moreover, due to the well-defined spatial resolution, the present method can be used for magnetic contrast applications.

The present invention further refers to a device for generating a magnetic field pattern, in particular a magnetic field gradient pattern, in particular for executing the previously described method for generating a magnetic field pattern. The device comprises an array with a plurality of current lines that each are in the form of a meander.

As already described, the expression "plurality of current lines" means that the array has at least two current lines or in other words two or more current lines that are in the form of a meander. It is further understood that the expression "each are in the form of a meander" refers to the plurality of current lines of the array and not to all current lines that the device has/may have. In other words, the device may have the array with the plurality of current lines that are in the form of a meander and at least one more current line that is not in the form of a meander. In other words, the proposed device for generating a magnetic field pattern, in particular a magnetic field gradient pattern, can be described as comprising at least two, i.e. two or more, current lines that each are in the form of a meander.

In an advantageous embodiment of the device, all the current lines of the device may be in the form of a meander.

The previously described features with regard to the proposed method apply to the device as well.

Advantageously, the device further comprises a control means for adjusting a direction and/or a value of a current that flows through at least one of the plurality of current lines of the array, in particular for adjusting it between 0.1A and 5A. According to an embodiment, the control means may be configured to adjust the current that flows through at least one of the plurality of current lines of the array between 0.1A and 1A. Advantageously, the control means is configured to adjust the value and/or the direction of the currents that flow through all current lines of the plurality of current lines of the array.

According to an embodiment, the device further comprises a substrate and is configured for remotely inducing masking of the substrate, wherein the current lines of the array are parallel to a substrate surface to be masked.

According to another embodiment, the device is configured for setting a spin orientation of atomic nuclei of a specimen intended for nuclear magnetic resonance imaging (MRI) at the microscale. This can in particular be done by setting (choosing for the device) the in-plane separation between said at least two current lines, in particular all the current lines, of the plurality of current lines of the array between 1µm and 2mm.

According to another embodiment, the device is configured for generating a magnetic field pattern on a sample, subjected to magnetic induction imaging (MII) at the microscale. This can in particular be done by setting (choosing for the device) the in-plane separation between 10µm and 10mm.

According to another embodiment, the device is configured for generating a magnetic field gradient pattern on a sample, subjected to Magnetic Resonance Microscopy (MRM) at the microscale. This can in particular be done by setting (choosing for the device) the in-plane separation between 10nm and 100µm.

The expression "setting the in-plane separation between..." means in other words that the device is formed such that the corresponding in-plane separation of the current lines lies in the corresponding aforementioned ranges.

According to an embodiment, the plurality of lines of the array may comprise a group of current lines that may advantageously be arranged on a first plane and a group of current lines that may advantageously be arranged on a second plane different from the first plane. In particular, the number of the current lines on the first plane (first current lines) may advantageously be equal to the number of the current lines on the second plane (second current lines).

It is noted that the terms "in particular" and "advantageously" in the description above denote optional/advantageous features of the present invention.

It is further noted that the term "between" when used for defining a value range means that the end values of the range are included. In other words, the corresponding value range is a closed range.

It is further noted that all combinations of the aforementioned ranges/values regarding the parameters (apparent length, width, thickness, current, in-plane separation, height separation) of the current lines are possible.

These and further details, advantages and features of the present invention will be described based on embodiments of the invention and by taking reference to the accompanying figures. Identical or equivalent elements and elements which act identically or equivalently are denoted with the same reference signs. Not in each case of their occurrence a detailed description of the elements and components is repeated.
Figure 1 shows a simplified cross section of a device for generating a magnetic field pattern according to a first embodiment of the present invention, with which the method of generating a magnetic field pattern according to the first embodiment can be executed.
Figure 2 shows a simplified schematic top view of part of the device of figure 1,
Figure 3a to 3c, Figures 4a to 4c and figures 5a to 5c show magnetic flux B maps with reference to the device of figure 1.
Figures 6a to 6c show the norm of the magnetic field.
Figures 7 to 9 show diagrams depicting the variation of the magnetic flux density norm depending on different parameters.
Figure 10 shows a diagram about the variation of the norm of the gradient between two spots depending on a parameter.
Figure 11 shows a simplified schematic top view of part of a device according to a second embodiment of the present invention.
Figure 12 shows a magnetic flux norm map of an array of current lines of the device of figure 11.
Figure 13 shows a single current line that is in the form of a meander,
Figure 14 shows the magnetic flux norm for the meander single current line of figure 13.

In the following, a device 100 and a method for generating a magnetic field pattern, in particular a periodic magnetic field, according to a fist embodiment of the present invention is described. More specifically, the device 100 is used for remotely inducing a mask on a substrate by generating a magnetic field pattern, in particular a magnetic field gradient pattern.

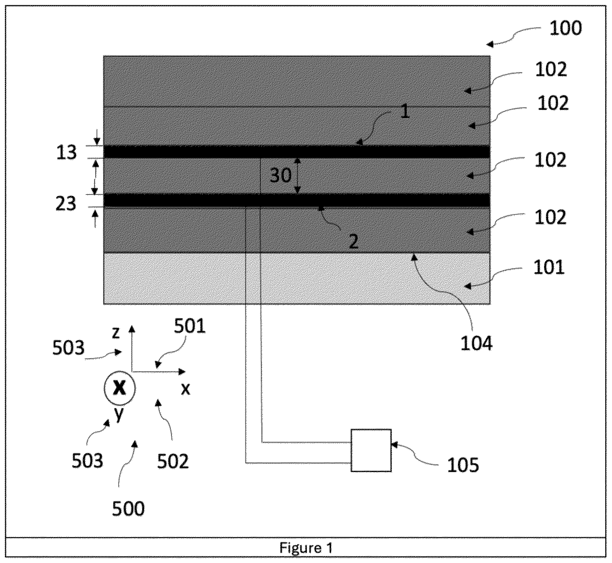

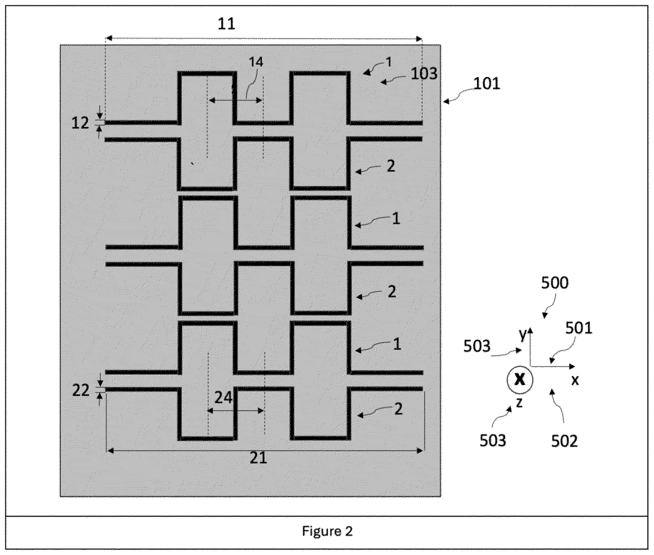

As can be seen from figures 1 and 2, the device 100 comprises a substrate 101 and a plurality of electrically insulating layers 102. In particular, the substrate 101 is a silicon substrate and the electrically insulating layers 102 are made of silicon dioxide. Other materials for the substrate 101 and/or the electrically insulating layers 102 are however possible.

The device 100 further comprises an array 103 with a plurality of current lines 1, 2 which in turn comprises a plurality/group of first current lines 1 and a plurality/group of second current lines 2. The first current lines 1 and the second current lines 2 are the only current lines of the device 100. The first current lines 1 and the second current lines 2 may be made of metal such as gold (Au) and silver (Ag), or other metals, intermetallic compound, or alloy thereof. Possible materials for the first current lines 1 and/or the second current lines 2 may also include graphene, semiconductors, topological insulators, and superconducting materials or combinations thereof. The first current lines 1 and/or the second current lines 2 may be made of the same material or different materials.

The device 100 and in particular the substrate 101 extends in a first direction, in a second direction and in a third direction, wherein the first direction is parallel to a first axis, also characterized as x-axis, the second direction is parallel to a second axis, also characterized as y-axis, and the third direction is parallel to a third axis, also characterized as z-axis, of an orthogonal coordinate system. The third axis of the orthogonal coordinate system is perpendicular to a plane defined by the first axis and the second axis and parallel to a normal of a substrate surface 104. The third direction defines a height direction of the device 100 and in particular of the substrate 101 as well as a thickness direction of a respective current line of the first current lines 1 and the second current lines 2. The second direction defines a width direction of the device 100 and in particular of the substrate 101. The first direction defines a length direction of the device 100 and in particular of the substrate 101 as well as an apparent length direction of a respective current line of the first current lines 1 and the second current lines 2.

The first current lines 1, the second current lines 2 and the electrically insulating layers 102 are arranged in the third direction. In particular, the electrically insulating layers 102 are arranged on the substrate 101. The first current lines 1 are provided on a first plane and the second current lines 2 on a second plane. In particular, the first current lines 1 and the second current lines 2 are arranged parallel to each other and at a height separation 30 between 0.5µm and 5µm.

According to figure 1, the first current lines 1 are arranged between two of the electrically insulating layers 102. Similarly, the second current lines 2 are arranged between two of the electrically insulating layers 102. In particular, one of the electrically insulating layers 102 is shared/arranged between the first current lines 1 and the second current lines 2. As denoted by their name, the electrically insulating layers 102 are provided for electrically insulating the first current lines 1 and the second current lines 2. In the present embodiment, four electrically insulating layers 102 are provided. However, this number can vary, in particular depending on the number of different planes on which current lines are arranged.

Figure 2 is a top view of part of the device 100 from which the electrically insulating layers 102 are removed to provide a better insight to the first current lines 1 and the second current lines 2. It can be seen from figure 2 that each of the first current lines 1 and each of the second current lines 2 are in the form of a meander that is parallel to the substrate surface 104 to be masked.

Each of the first current lines 1 and each of the second current lines 2 are arranged such that the second current lines 2 are rotated by 180 degrees compared to the first current lines 1. In other words, the first current lines 1 and the second current lines 2 are mirrored with respect to the first direction being parallel to the first axis 501.

A first apparent length 11 of each of the first current lines 1 and a second apparent length 21 of each of the second current lines 2 is between 0.9mm and 1.1mm, in particular equal to 1mm. In the present embodiment, all the current lines 1, 2 of the array 103 have the same apparent length.

A first width 12 of each of the first current lines 1 and a second width 22 of each of the second current lines 2 is between 40µm and 60µm, in particular equal to 50µm. In the present embodiment, all the current lines 1, 2 of the array 103 have the same width.

A first thickness 13 of each of the first current lines 1 and a second thickness 23 of each of the second current lines 2 each lie between 0.4µm and 0.6µm, in particular are each equal to 0.5µm. In the present embodiment, all the current lines 1, 2 of the array 103 have the same thickness.

A first in-plane separation 14 of the first current lines 1 is between 100µm and 250µm. Further, a second in-plane separation 24 of the second current lines 2 is also between 100µm and 250µm. In the present embodiment, all the current lines 1,2 of the array 103 have the same in-plane separation.

The device 100 further comprises a control means 105 for adjusting a direction and value of a current through the first current lines 1 and the second current lines 2. The current through the first current lines 1 and the current through the second current lines 2 may be set to have the same or different values and/or directions. In particular, the control means 105 may be configured to adjust said current values between 0.1A and 1A. In other words, the device 100 is configured such that a current that flows through the first current lines 1 and the second current lines 2 is adjustable.

The substrate 101 can be masked with the method for generating a magnetic field pattern according to the present embodiment. More specifically, in the present embodiment, said method is used for magnetic field induced masking of a substrate according to the present embodiment. The method comprises the step of masking the substrate by using the previously described array 103 of current lines, i.e. the first current lines 1 and the second current lines 2. To this end, the method comprises the step of adjusting the current through the first current lines 1 and the second current lines 2 as described above.

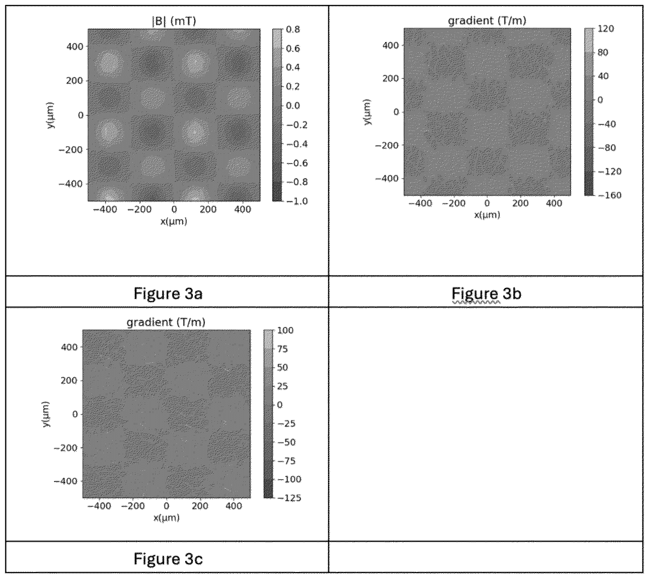

Figures 3a to 3c, 4a to 4c and 5a to 5c show magnetic flux B maps for the array 103.

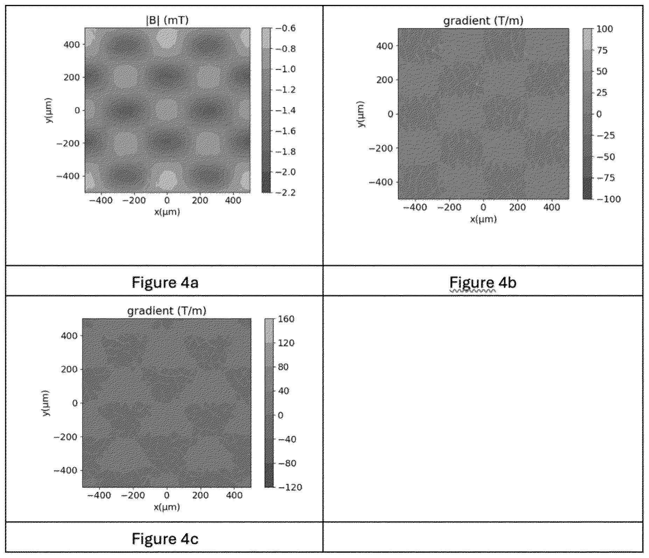

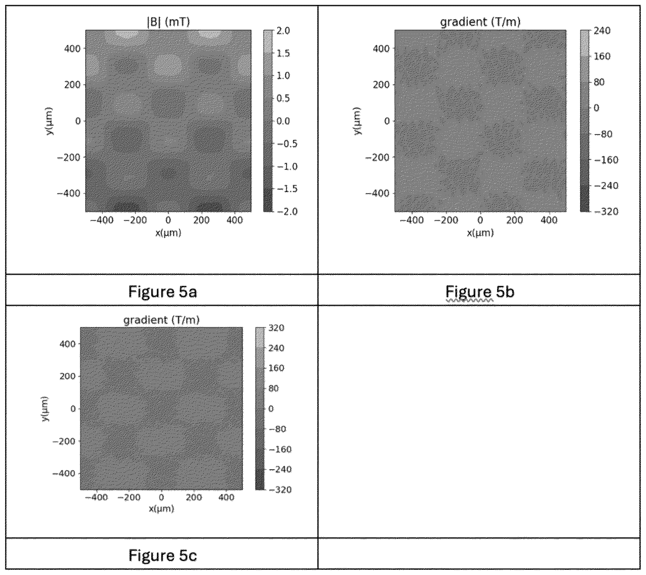

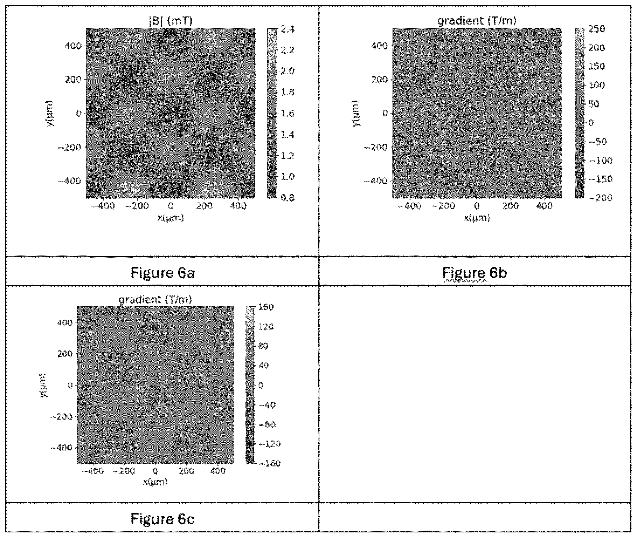

Figures 3a to 3c show the x, y components of the gradient of the x field component and the norm of the x field component (from 3a to 3c). Similarly, figures 4a to 4c show the x, y components of the gradient for the y field component, while figures 5a to 5c shows the x, y components of the gradient of the z field component. Figures 6a to 6c give the norm of the field.

In all these figures, the first thickness 13 of the first current lines 1 and the second thickness 23 of the second current lines 2 equal to 0.5 µm, while the first width 12 of the first current lines 1 and the second width 22 of the second current lines 2 equal to 50 µm. The first apparent length 11 of the first current lines 1 and the second apparent length 21 of the second current lines 2 are equal to 1 mm. The in-plane separation of the first current lines 1 and the in-plane separation of the second current lines 2 equal to 200 µm. Through the first current lines 1 and the second current lines 2, a current of 0.5 A flows. The currents that flow through the first current lines 1 and the second current lines 2 are parallel to each other, i.e. they flow in the same direction.

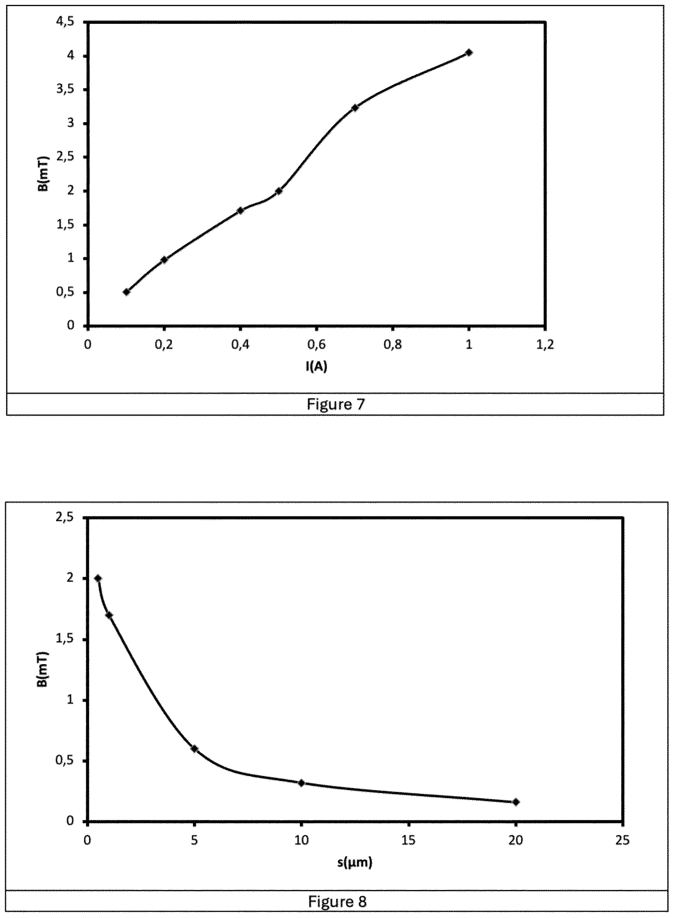

Figures 7 to 9 show diagrams depicting the variation of the magnetic flux density norm depending on different parameters.

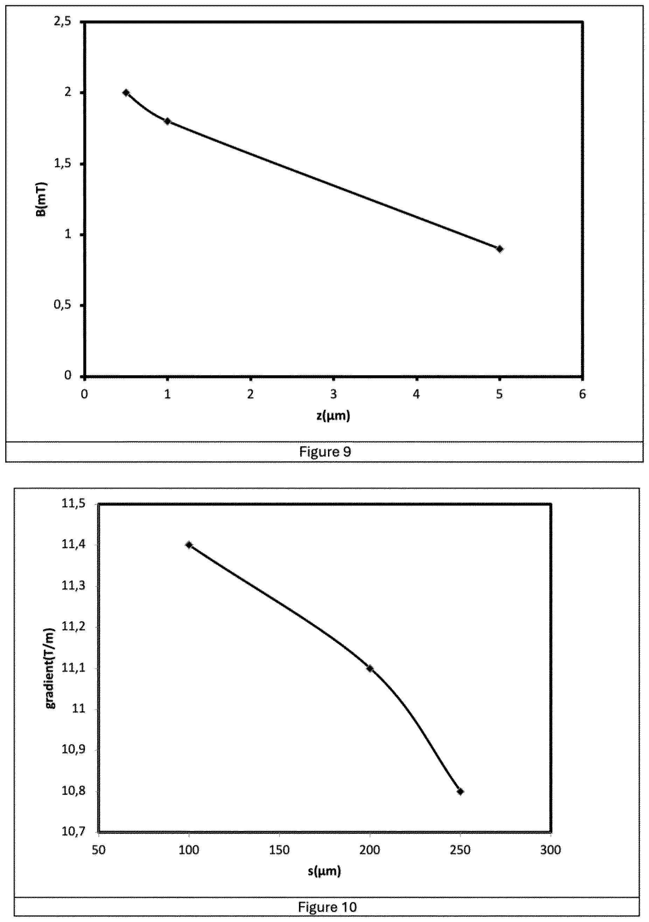

In particular, figure 7 shows the variation of the magnetic flux density norm with respect to the current through the first currents lines 1 and the second current lines 2. Figure 8 shows the variation of the magnetic flux density norm with respect to the separation of the first current lines 1 or the separation of the second current lines 2 for a fixed current. Figure 9 shows the variation of the magnetic flux density norm with respect to the height separation of the second current lines 2 from the first current lines 1.

Figure 10 shows a diagram about the variation of the norm of the gradient between two spots with respect to the separation of the first current lines 1 or the separation of the second current lines 2.

Figures 7 to 10 can be used as a guide for the on-demand parameter tuning of the array 103.

As previously mentioned, the method for magnetic field induced masking of a substrate can be part of a magnetic lithography method. The scope of magnetic lithography is to aggregate magnetic nanoparticles over designated areas of the surface (mask) via spatially varying magnetic fields. By the present method for magnetic field induced masking of a substrate, the array 103 of current lines (elements) drives remotely the assembly of different masking patterns made of magnetic particles. The usage of the first current lines 1 and the second current lines 2 allows to construct arbitrary 2D structures by varying the current direction. Moreover, the strength of the fields is tuneable by the strength of the currents that flow through the first current lines 1 and the second current lines 2 of the array 103. A magnetic field distribution with almost homogenous field regions (spots) can be produced by the described method in order to provide high contrast and a sufficient gradient between them to drive the magnetic particles. A further advantage of the described method is that the resolution of the mask can also be tuned by varying the geometric characteristics of the first current lines 1 and the second current lines 2 of the array 103.

The described method can be used within a magnetic lithography method for manufacturing/fabricating a photovoltaic device. However, this technique can be used in various biomedical and technological applications.

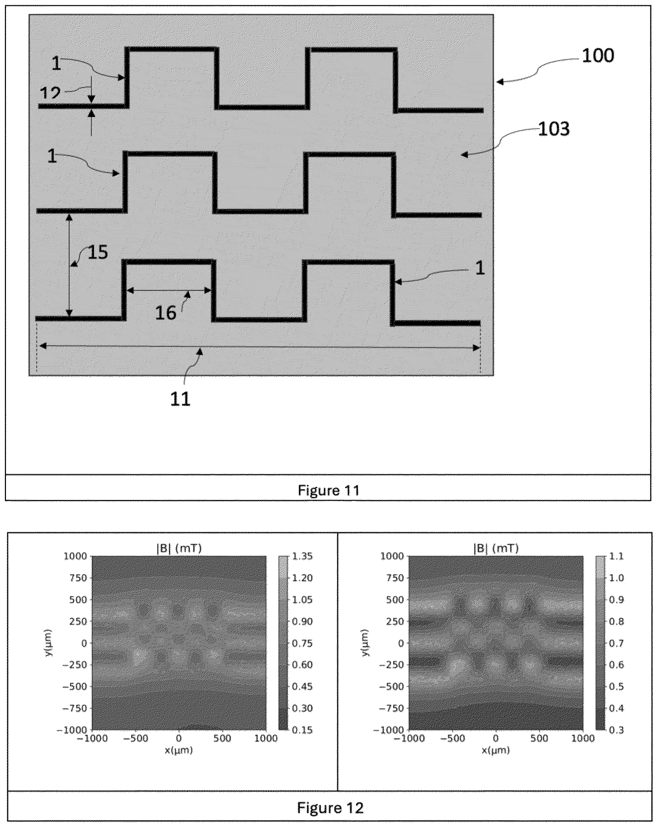

Figures 11 and 12 refer to a second embodiment of the present invention.

As can be seen from figure 11, the second embodiment differs from the first embodiment in that the array 103 of the current lines of the second embodiment comprises only the first current lines 1. An offset 15 between the first current lines 1 in the width direction is advantageously twice as much as a separation 16 of the parts of the first current lines 1 that extend in the width direction of the substrate 101. These parts of the first current lines 1 that extend in the width direction of the substrate 101 can also be characterized as non-straight line parts as compared to the parts of the first current lines 1 that extend in the length direction of the substrate 101. Thus, the step of masking of the method for generating a magnetic field pattern and in particular for magnetic field induced masking of a substrate according to the present embodiment is done by using the array 103 of current lines having only the first current lines 1.

Figure 12 shows a magnetic flux norm map of the array of figure 11 with a 150 µm line separation of meander's non-straight line parts (left panel) and a 200 µm separation of meander's non-straight line parts (right panel). The current here is 0.4 A.

The advantages described with regard to the first embodiment apply to this embodiment too.

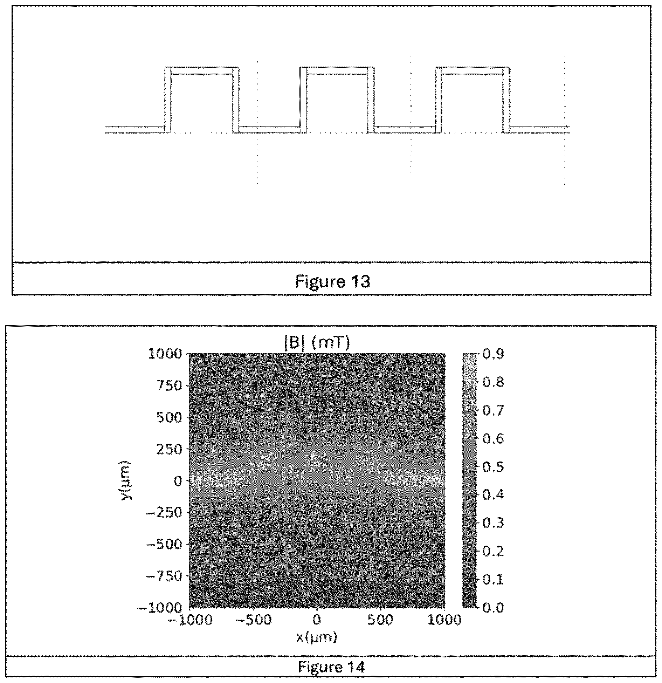

Figures 13 and 14 refer to a single current line that is in the form of a meander and are described in order to highlight the advantages of the present invention, namely of using the device 100 with the array 103 of current lines that has at least two current lines.

Figure 13 depicts the single current line in the form of a meander, while figure 14 presents the magnetic flux norm for the meander single current line of figure 13. Interestingly, even for a single current line, it is evident that spots of uniform magnetic field gradient can be created.

Though the device 100 has been described as a device for remotely inducing a mask on a substrate by generating a magnetic field pattern, its design regarding the substrate 101 and the plurality of electrically insulating layers 102 can be used for the other applications mentioned above. Nevertheless, the values for the parameters of the current lines (apparent length, width, thickness, current, in-plane separation, height separation) can be application-specific.

### List of reference signs

- 1: first current line
- 2: second current lines
- 11: first apparent length
- 12: first width
- 13: first thickness
- 14: first in-plane separation
- 15: offset
- 16: separation
- 21: second apparent length
- 22: second width
- 23: second thickness
- 24: second in-plane separation
- 30: height separation
- 100: device
- 101: substrate
- 102: electrically insulating layers
- 103: array
- 104: substrate surface
- 105: control means
- 500: orthogonal coordinate system
- 501: first axis
- 502: second axis
- 503: third axis

## Claims

1. A method for generating a magnetic field pattern, in particular a magnetic field gradient pattern, comprising the step of generating a magnetic field pattern, in particular a magnetic field gradient pattern, by using an array (103) with a plurality of current lines (1, 2; 1) that each are in the form of a meander.

2. The method of claim 1, wherein:
an apparent length (11, 21; 11) of at least one of the plurality of current lines (1, 2; 1) of the array (103) is between 1.0mm and 5m,
and/or
a width of at least one of the plurality of current lines (1, 2; 1) of the array (103) is between 10nm and 2cm
and/or
a thickness (12, 22; 12) of at least one of the plurality of current lines (1, 2; 1) of the array (103) is between 0.4µm and 2cm,
and/or
wherein at least two of the plurality of current lines (1, 2; 1) of the array (103) are shaped identically.

3. The method of any of the preceding claims, wherein at least two current lines (1, 2; 1) of the plurality of current lines of the array (103) are arranged on the same plane, wherein an in-plane separation (41, 42; 41) of said at least two current lines (1, 2; 1) is between 20nm and 1m.

4. The method of any of the preceding claims, wherein at least two current lines (1, 2) of the plurality of the current lines of the array (103) are arranged parallel to each other and in particular at a height separation (30) between 0.5µm and 5cm.

5. The method of any of the preceding claims, wherein at least two current lines (1, 2) of the plurality of current lines of the array (103) are arranged such they are rotated to each other by an angle between 0 and 180 degrees, preferably by 180 degrees, around an axis perpendicular to the planes of the at least two current lines (1, 2).

6. The method of any of the preceding claims, wherein a direction and/or a value of a current that flows through at least one of the plurality of current lines (1, 2; 1) of the array (103) is adjustable, in particular between 0.1A and 5A,
and/or wherein a current that flows through at least one of the plurality of current lines (1, 2;1) has a predetermined shape variation.

7. The method of any of the preceding claims, wherein at least one of the plurality of current lines (1, 2; 1) of the array (103) is made of a material that comprises a metal and/or an intermetal compound and/or a metallic alloy and/or graphene and/or a superconducting material and/or a semiconductor and/or a topological insulator.

8. A device (100) for generating a magnetic field pattern, in particular a magnetic field gradient pattern, in particular for executing a method for generating a magnetic field pattern according to any of the preceding claims, comprising:
an array (103) with a plurality of current lines (1, 2; 1) that each are in the form of a meander.

9. The device (100) of claim 8 wherein:
an apparent length (11, 21; 11) of at least one of the plurality of current lines (1, 2; 1) of the array (103) is between 1.0mm and 5m,
and/or
a width of at least one of the plurality of current lines (1, 2; 1) of the array (103) is between 10nm and 2cm,
and/or
a thickness (12, 22; 12) of at least one of the plurality of current lines (1, 2; 1) of the array (103) is between 0.4µm and 2cm,
and/or
wherein at least two of the plurality of current lines (1,2; 1) are shaped identically.

10. The device (100) of claim 8 or 9, wherein at least two current lines (1, 2; 1) of the plurality of current lines of the array (103) are arranged on the same plane, wherein an in-plane separation (41, 42; 41) of said at least two current lines (1, 2; 1) is between 20nm and 1m.

11. The device (100) any of claims 8 to 10, wherein at least two current lines (1, 2) of the plurality of the current lines of the array (103) are arranged parallel to each other and in particular at a height separation (30) between 0.5µm and 5cm.

12. The device (100) of any of claims 8 to 11, wherein at least two current lines (1, 2) of the plurality of current lines of the array (103) are arranged such they are rotated to each other by an angle between 0 and 180 degrees, preferably by 180 degrees, around an axis perpendicular to the planes of the at least two current lines (1, 2).

13. The device (100) of any of claims 8 to 12, further comprising a control means (105) for adjusting a direction and/or a value of a current that flows through at least one of the plurality of current lines (1, 2; 1) of the array (103), in particular for adjusting it between 0.1A and 5A.

14. The device (100) of any of claims 8 to 13, wherein at least one of the plurality of current lines (1, 2; 1) of the array (103) is made of a material that comprises a metal and/or an intermetal compound and/or a metallic alloy and/or graphene and/or a superconducting material and/or a semiconductor and/or a topological insulator.

15. The device (100) of any of claims 8 to 14, wherein:
the device (100) further comprises a substrate (101) and is configured for remotely inducing masking of the substrate (101), wherein the current lines (1, 2; 1) of the array (103) are parallel to a substrate surface (104) to be masked,
or
the device (100) is configured for setting a spin orientation of atomic nuclei of a specimen intended for nuclear magnetic resonance imaging at the microscale, in particular by setting the in-plane separation between 1µm and 2mm.
or
the device (100) is configured for generating a magnetic field field gradient pattern on a sample, subjected to magnetic induction imaging at the microscale, in particular by setting the in-plane separation between 10µm and 10mm.
or
the device (100) is configured for generating a magnetic field gradient pattern on a sample, subjected to Magnetic Resonance Microscopy at the microscale, in particular by setting the in-plane separation between 10nm and 100µm.
